# EUROPEAN PATENT APPLICATION

(11) **EP 4 715 346 A1**
(43) Date of publication of application: **25.03.2026**
(21) Application number: 24807276.1
(22) Date of filing: 16.05.2024
(51) Int. Cl.: G01J 1/02, H01L 21/822, H01L 27/04, H10N 15/00

(54) **THERMAL DETECTOR**

(30) Priority: 17.05.2023 JP 2023081418; 04.10.2023 JP 2023173142
(71) Applicant: Keio University, Tokyo, 108-8345 (JP)
(72) Inventor: MAKI, Hideyuki, Yokohama-shi, Kanagawa 223-8522 (JP)
(74) Representative: Piotrowicz, Pawel Jan Andrzej
(86) International application number: PCT/JP2024/018234
(87) International publication number: WO 2024/237326

(57) **Abstract**

A thermal detector includes a substrate; a nanocarbon material layer bridged over the substrate; a temperature-dependent resistance-changing material layer supported by the nanocarbon material layer; and a pair of electrodes connected to at least one of the resistance-changing material layer or the nanocarbon material layer.

## Description

### TECHNICAL FIELD

The present invention relates to a thermal detector. More specifically, the present invention relates to a thermal detector using a nanocarbon material, such as graphene, a nanocarbon tube, or the like, as a support film or a diaphragm.

### BACKGROUND ART

As optical detectors, not only a photoelectric effect detector, such as a photodiode or the like, but also a thermal effect detector (hereinafter referred to simply as a "thermal detector"), such as a bolometer or the like is known. The thermal detector is configured to detect incident light using temperature-dependent resistance change of a metal or semiconductor. The thermal detector is used at room temperature or a low temperature, especially as an infrared detector. A similar detection principle is used in an electromagnetic wave detector referred to as a calorimeter. When a superconductor is used as a material that exhibits temperature-dependent resistance change, the thermal detector is applied as an ultrasensitive optical detector, a single-photon detector, a calorimeter, a transition-edge sensor (TES), or the like, to detect light, photons, molecules, and the like.

The thermal detector mainly uses a semiconductor, such as amorphous silicon or the like, or a metal oxide, such as vanadium oxide or the like, as a resistance-changing material that operates at room temperature. A high-sensitive thermal detector that operates at a cryogenic temperature uses a superconductor, such as niobium nitride or the like. These thermal detectors include a heat insulating structure between a sensing portion and the external environment, such as a substrate or the like, thereby preventing heat dissipation when light is incident. This is for preventing detection sensitivity from decreasing due to temperature reduction caused by heat dissipation.

As a configuration for preventing heat dissipation, a support film structure in which semiconductors, such as silicon, silicon nitride, and the like, and insulators are suspended in the air is produced using MEMS (micro electro mechanical system) technology. The support film structure avoids thermal contact between the sensing portion and the substrate to suppress dissipation of heat to the substrate, thereby preventing reduction in sensitivity. The resistance-changing material, such as amorphous silicon, vanadium oxide, or the like, is formed on a surface of the support film structure farther from the substrate, thereby obtaining sufficient temperature change and detecting light with high sensitivity. A bolometer in which a bolometer film containing carbon nanotubes is coated on a diaphragm with support legs of silicon nitride is proposed (see, for example, Patent Document 1). It is known to use carbon nanotubes and a metal conductor thin film for a magneto resistive element (see, for example, Patent Document 2).

### RELATED ART DOCUMENTS

### PATENT DOCUMENTS

Patent Document 1: Japanese Laid-Open Patent Application Publication No. 2022-25052
Patent Document 2: Japanese Laid-Open Patent Application Publication No. 2005-39228

### SUMMARY OF THE INVENTION

### PROBLEM TO BE SOLVED BY THE INVENTION

Conventional thermal detectors use silicon or silicon nitride for forming a support structure. Specifically, silicon or silicon nitride is used to form a support film structure in which a film having a thickness of about 0.1 µm is suspended in the air, and a resistance-changing material is applied onto the support film. The support film has a certain thickness and a considerable heat capacity. Due to the support film structure having a certain thickness and a large heat capacity, the resistance-changing material does not sharply change in temperature, and the large heat capacity reduces a response speed. Typically, heat conductivity or the like of the support film structure is substantially fixed as a value intrinsic to the material, and thus it is difficult to control the heat conductivity of the support film. Therefore, in conventional configurations, sensitivity and performance are controlled by optimizing the structure, length, and width of the support legs that support the support film. However, there is a limit to controlling the performance by structural design, and thus it is desired to establish a new way to control characteristics for thermal detectors.

It is an object of the present invention to provide a thermal detector that is thinner, faster, and more sensitive than conventional silicon-based thermal detectors.

### MEANS FOR SOLVING THE PROBLEM

The present invention provides a thermal detector using, as a support structure, a nanocarbon material capable of being thinned in an atomic order, instead of a conventional silicon-based thermal detector. Focusing on a bridging structure of the nanocarbon material, the present invention provides a thermal detector having a new structure in which a resistance-changing material layer is supported by a bridged nanocarbon material layer.

Specifically, a thermal detector includes: a substrate;
a nanocarbon material layer bridged over the substrate;
a temperature-dependent resistance-changing material layer supported by the nanocarbon material layer; and
a pair of electrodes connected to at least one of the resistance-changing material layer or the nanocarbon material layer.

### ADVANTAGEOUS EFFECTS OF THE INVENTION

Compared to silicon-based thermal detectors, a thinner, high-speed, and highly sensitive thermal detector is realized.

### BRIEF DESCRIPTION OF THE DRAWINGS

[FIG. 1A] FIG. 1A is a schematic top diagram of a thermal detector of a first embodiment.
[FIG. 1B] FIG. 1B is a schematic cross-sectional diagram of the thermal detector of the first embodiment.
[FIG. 2A] FIG. 2A is a schematic top diagram of a modified example of the thermal detector of the first embodiment.
[FIG. 2B] FIG. 2B is a schematic cross-sectional diagram of the modified example of the thermal detector of the first embodiment.
[FIG. 3A] FIG. 3A is a schematic top diagram of a thermal detector of a second embodiment.
[FIG. 3B] FIG. 3B is a schematic cross-sectional diagram of the thermal detector of the second embodiment.
[FIG. 4A] FIG. 4A is a schematic top diagram of a thermal detector of a third embodiment.
[FIG. 4B] FIG. 4B is a schematic cross-sectional diagram of the thermal detector of the third embodiment.
[FIG. 5A] FIG. 5A is a schematic top diagram of a thermal detector of the third embodiment.
[FIG. 5B] FIG. 5B is a schematic cross-sectional diagram of the thermal detector of the third embodiment.
[FIG. 6A] FIG. 6A is a schematic top diagram of a thermal detector of a fourth embodiment.
[FIG. 6B] FIG. 6B is a schematic cross-sectional diagram of the thermal detector of the fourth embodiment.
[FIG. 7] FIG. 7 is a schematic plan diagram illustrating a state prior to formation of a resistance-changing material layer in a thermal detector of a fifth embodiment.
[FIG. 8] FIG. 8 is a schematic plan diagram illustrating a state prior to formation of a resistance-changing material layer in a modified example of the fifth embodiment.
[FIG. 9] FIG. 9 is a schematic plan diagram illustrating a state prior to formation of a resistance-changing material layer in a modified example of the fifth embodiment.
[FIG. 10] FIG. 10 is a schematic diagram illustrating production of a thermal detector of a sixth embodiment.
[FIG. 11] FIG. 11 is a scanning electron microscope (SEM) image of a bridged resistance-changing material layer supported by a nanocarbon material layer.
[FIG. 12] FIG. 12 is a schematic diagram of a detection device according to a seventh embodiment.
[FIG. 13] FIG. 13 is a graph illustrating an example of an electrical resistance with respect to a temperature in vanadium oxide.
[FIG. 14A] FIG. 14A is a graph illustrating ΔV with respect to laser power in Sample A.
[FIG. 14B] FIG. 14B is a graph illustrating ΔV with respect to laser power in Sample A.
[FIG. 14C] FIG. 14C is a graph illustrating ΔV with respect to laser power in Sample A.
[FIG. 15A] FIG. 15A is a graph illustrating ΔV with respect to a bias current in Sample A.
[FIG. 15B] FIG. 15B is a graph illustrating ΔV with respect to laser power in Sample A.
[FIG. 16A] FIG. 16A is a graph illustrating ΔV with respect to laser power in Sample B.
[FIG. 16B] FIG. 16B is a graph illustrating ΔV with respect to laser power in Sample B.
[FIG. 17] FIG. 17 is a graph illustrating ΔV with respect to a bias current in Sample B.
[FIG. 18] FIG. 18 is a graph illustrating ΔV with respect to a bias current in Sample C.

### EMBODIMENTS FOR CARRYING OUT THE INVENTION

In the following, thermal detectors of embodiments will be described in detail with reference to the drawings. The embodiments described below are illustrative for embodying the technical idea of the invention, and should not be construed as limiting the present invention to the following configurations and numerical values. In the drawings, members having the same function are denoted by the same reference sign, and duplicate description thereof may be omitted. Partial substitution or combination between different embodiments or configuration examples is possible. The size, positional relationship, and the like of the members as illustrated in each drawing may be exaggerated for ease of understanding of the invention.

### (First Embodiment)

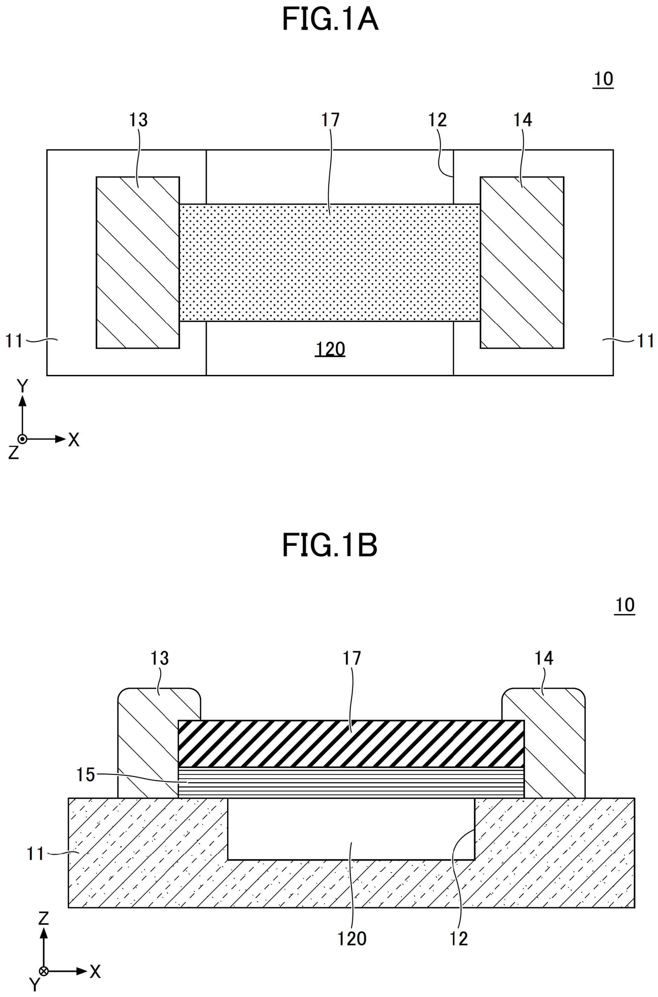

FIGS. 1A and 1B are schematic diagrams of a thermal detector 10 of a first embodiment. FIG. 1A is a top diagram of the thermal detector 10, and FIG. 1B is a cross-sectional diagram of the thermal detector 10. The thermal detector 10 includes a recess 12 provided in a substrate 11, a nanocarbon material layer 15 bridged over the recess 12, a temperature-dependent resistance-changing material layer 17 supported by the nanocarbon material layer 15, and a pair of electrodes 13 and 14 connected to at least one of the resistance-changing material layer 17 or the nanocarbon material layer 15. In the coordinate system of FIGS. 1A and 1B, a plane parallel to the surface of the substrate 11 is an XY plane, and a thickness direction of the substrate 11 is a Z direction. In the first embodiment, the nanocarbon material layer 15 is bridged over the recess 12 to function as a support film for supporting the resistance-changing material layer 17, and a space 120 is formed below the nanocarbon material layer 15. The recess 12 is a structure over which the nanocarbon material layer 15 is bridged, and the substrate 11 only needs to have a structure over which the nanocarbon material layer 15 is bridged. The structure over which the nanocarbon material layer 15 is bridged may be any structure other than the recess 12. Thus, the nanocarbon material layer 15 is bridged over the substrate 11. In the following embodiments, it is sufficient that the nanocarbon material layer 15 is bridged over the substrate 11.

The nanocarbon material layer 15 is formed of a nanocarbon material, such as graphene (including multilayer graphene and polycrystalline graphene), a carbon nanotube, or the like. The temperature-dependent resistance-changing material layer 17 is deposited on the nanocarbon material layer 15 to detect the temperature from the resistance change. In a bridged portion covering the recess 12, the space 120 exists between: the nanocarbon material layer 15 and the resistance-changing material layer 17; and the substrate 11, thereby suppressing dissipation of heat to the substrate 11. Suppressing the dissipation of heat increases the temperature change of the resistance-changing material layer 17 that forms a sensing portion or a light receiving portion of the thermal detector 10. The increased temperature change enables high-sensitive detection.

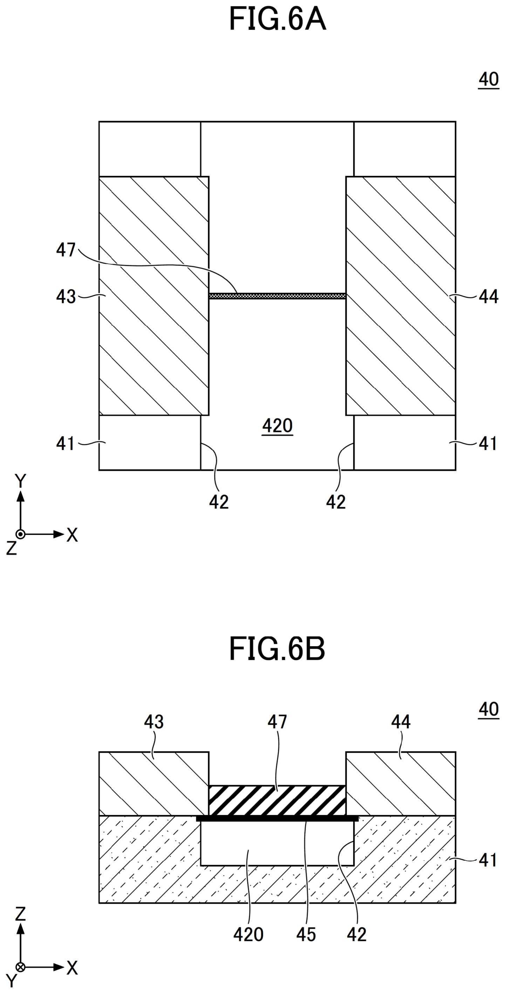

The thermal detector 10 uses the nanocarbon material layer 15 as a support film, and the resistance-changing material layer 17 is supported by the nanocarbon material layer 15. A planar shape of the nanocarbon material layer 15 may be any shape. The resistance-changing material layer 17 may have a simple rectangular shape as illustrated in FIGS. 1A and 1B, or may have any of various shapes, such as a linear shape, a meandering shape, a combination of patches and strips, and the like, as described below with reference to FIG. 6A and subsequent drawings. The resistance-changing material layer 17 is formed of a metal oxide, such as vanadium oxide or the like, a semiconductor, such as silicon, amorphous silicon, or the like, or a metal, such as platinum or the like. The resistance-changing material layer 17 may use any material, such as a metal material, a semiconductor material, a metal oxide, or the like, as long as the material is a conductive material that changes in resistance in accordance with temperature change. The resistance-changing material layer 17 can operate according to the same principle at a desired operation temperature, i.e., a low temperature, room temperature, or a high temperature. The planar shape of the resistance-changing material layer 17 can have any of various shapes in accordance with the shape of the nanocarbon material layer 15.

In operation at room temperature, vanadium oxide and amorphous silicon exhibit large temperature-dependent resistance change in the vicinity of room temperature and thus operate without cooling. When a superconductor is used, very large resistance change can be obtained in the vicinity of the superconducting transition temperature, and thus sensitivity can be increased. Superconductors operate in the vicinity of the superconducting transition temperature, and typically operate at low temperatures. Superconductors greatly change in electrical resistance from zero to finite resistance around the superconducting transition temperature, and thus can be applied to the detection of a single photon and weak light, the detection of particles including atoms and molecules, the detection of radiation, calorimeters configured to detect slight temperature change, sensing of chemical reactions, and the like.

A nanocarbon material may be used as the resistance-changing material layer 17. In this case, since the resistance-changing material layer 17 is formed of the same material as that of the nanocarbon material layer 15 to be bridged, resulting in simplified production. That is, the thermal detector 10 is produced without depositing another substance on the surface of the nanocarbon material layer 15. In addition to the simplicity of a device production process, the high heat conductivity of the nanocarbon material enables high-speed detection. Also, when the nanocarbon material is used as the resistance-changing material layer 17, the resistance-changing material layer 17 and the nanocarbon material layer 15 can be very thinned. This decreases the heat capacity to increase the temperature change. Thus, it is possible to achieve high sensitivity and high-speed operation. In this specification, the description of "the resistance-changing material layer 17 on the nanocarbon material layer 15" includes a configuration in which a portion of the nanocarbon material is used as the nanocarbon material layer 15 and another portion of the nanocarbon material is used as the resistance-changing material layer 17. Graphene usable as the resistance-changing material layer 17 includes monolayer graphene, multilayer graphene, or monolayer or multilayer polycrystalline graphene. Carbon nanotubes usable as the resistance-changing material layer 17 include a single carbon nanotube, a carbon nanotube thin film formed through aggregation of carbon nanotubes, and the like. In either case, it is important to form a structure in which any of these layers is bridged.

In the following description, the temperature-dependent resistance-changing material layers 17 of a metal oxide, a semiconductor, a metal, a superconductor, a nanocarbon material, and the like are collectively referred to as the "resistance-changing material layer", but any of the above-described materials may be used as the resistance-changing material layer 17.

Regarding a light receiving principle of the thermal detector 10, not only a bolometer configured to detect resistance change, but also any detection principle may be employed as long as temperature change can be detected as electrical change. The thermal detector refers to a device configured to enable electrical detection due to change in resistance, an electromotive force, a current, or the like in accordance with a temperature, and is not limited to a device configured to perform resistance measurement. Therefore, the temperature change may be detected as voltage change or current change. For example, a light receiving element of a thermal electromotive force type is also included in the thermal detector 10 of the embodiment. In the following description, a device configured to perform resistance detection, voltage detection, or current detection based on temperature change is referred to as a "thermal detector". When detecting resistance based on temperature change, any method may be used, such as a method of applying a bias current and measuring a potential difference to calculate resistance, a method of applying a bias voltage and measuring a current to calculate resistance, a method of forming a bridge circuit to measure resistance, or the like.

Nanocarbon materials have a very high mechanical strength compared to a typical material, such as a metal, a semiconductor, or an insulator. The nanocarbon material layer 15 can be formed in various thicknesses and shapes, and has a high degree of freedom in design regarding heat dissipation. The nanocarbon material layer 15 can be formed as a very thin film. The heat capacity can be controlled in accordance with the thickness and shape of the nanocarbon material layer 15. When the nanocarbon material is used, an ultrathin bridging structure can be achieved to extremely reduce the heat capacity. By adjusting the heat capacity of the nanocarbon material layer 15, it is possible to control the response speed and sensitivity of the thermal detector 10. When the thin nanocarbon material layer 15 is used, the resulting very low heat capacity simultaneously realizes high sensitivity due to the great temperature change and high-speed operation due to the low heat capacity.

Also, the nanocarbon material has very high heat conductivity. In particular, the nanocarbon material with high quality exhibits high heat conductivity. It is known that a single-crystal nanocarbon material with less defects has a heat conductivity ten times or greater that of a typical material, such as a metal, a semiconductor, or an insulator. The increase in temperature in the resistance-changing material layer 17 is rapidly conducted in the form of heat through the nanocarbon material layer 15 in a plane direction, and heat is rapidly conducted to the electrodes 13 and 14 in contact with the nanocarbon material layer 15. Since heat conduction is increased compared to typical material systems, a high-speed operable thermal detector can be realized. The nanocarbon material has a small heat capacity, and thus can achieve both high sensitivity and high-speed operation by permitting a certain degree of heat conductivity.

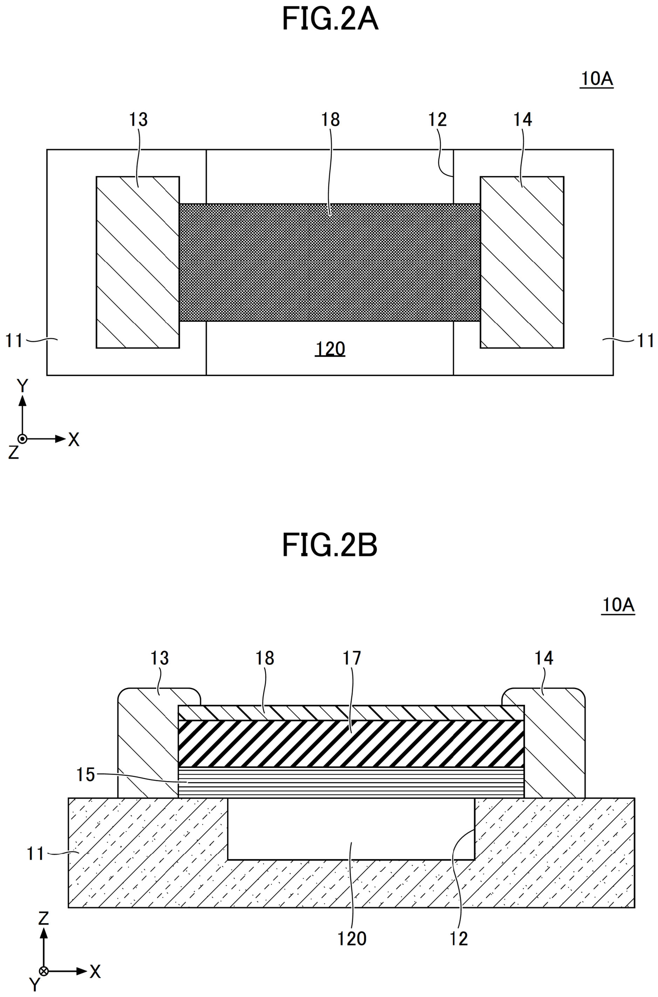

FIGS. 2A and 2B are schematic diagrams of a thermal detector 10A of a modified example of the first embodiment. The thermal detector 10A includes a light absorbing layer 18 on the resistance-changing material layer 17 to increase detection sensitivity. The light absorbing layer 18 for increasing sensitivity may be provided as a portion of the resistance-changing material layer 17.

The thermal detectors 10 and 10A of the first embodiment have a structure in which the resistance-changing material layer 17 is disposed on the nanocarbon material layer 15 for forming a bridging structure, and a space 120 for bridging is provided below the nanocarbon material layer 15. Here, the formation of the nanocarbon material layer 15, the formation of the resistance-changing material layer 17, and the formation of the recess 12 may be performed in any order. The recess 12 can be formed by etching the substrate 11. After the nanocarbon material layer 15 or the resistance-changing material layer 17, formed in a specific shape through lithography or the like, is formed over the substrate 11, a portion of the substrate 11 below the nanocarbon material layer 15 may be removed by etching the substrate 11, thereby establishing bridging. For example, when an oxide film-containing silicon substrate (SiO₂/Si substrate) is used, the SiO₂ film can be etched by a solution or hydrofluoric acid in a gaseous phase. The Si substrate may be etched by XeF₂ gas. An appropriate etching gas or etchant can be selected in accordance with the material of the substrate 11.

Alternatively, the nanocarbon material layer 15 may be bridged over the substrate 11 in which the recess 12 was previously formed, and the resistance-changing material layer 17 may be deposited using the bridged nanocarbon material layer 15 as a template. This method does not need to form the resistance-changing material layer 17 through lithography or etching, and thus is a very simple method that can form the resistance-changing material layer 17 on the nanocarbon material layer 15 covering the space 120. Since the resistance-changing material layer 17 can be formed using, as a template, the nanocarbon material layer 15 that is suitable for microfabrication, this is very useful as a method of producing the thermal detector 10 or 10A using the resistance-changing material layer 17 having a desired shape or a minute shape.

The nanocarbon material layer 15 can be used as a template for the bridging structure to serve as a base layer for fabrication of the bridging structure. When the resistance-changing material layer 17 is formed through chemical vapor deposition or the like, the resistance-changing material layer 17 can be formed not only on the top surface of the nanocarbon material layer 15 but also on the bottom surface or the side surface of the nanocarbon material layer 15, i.e., the resistance-changing material layer 17 can be formed around the nanocarbon material layer 15.

In the thermal detector 10 or 10A, as illustrated in FIGS. 1A, 1B, 2A, and 2B, the resistance-changing material layer 17 is supported by the nanocarbon material layer 15 that is connected between the electrodes 13 and 14. In this configuration, by increasing the distance between the electrodes 13 and 14, the dissipation of heat to the electrodes 13 and 14 can be reduced to increase the sensitivity of the thermal detector 10 or 10A. Conversely, by reducing the distance between the electrodes 13 and 14, the conduction of heat to the electrodes 13 and 14 can be enhanced to achieve high-speed operation.

In FIGS. 1A, 1B, 2A, and 2B, a graphene film may be used as the nanocarbon material layer 15 for the bridging structure. In this case, the resistance-changing material layer 17 is disposed on the graphene film bridged over the recess 12, and the space 120 is provided below the graphene film. When the graphene film is used as the nanocarbon material layer 15, the formation of the graphene film, the formation of the resistance-changing material layer 17, and the etching of the substrate 11 for forming the bridging structure may be performed in any order. As a graphene crystal, single-crystal graphene or polycrystal graphene may be used. The formation of the graphene film may be performed by any method, such as mechanical exfoliation, chemical vapor deposition, SiC sublimation growth, solid carbon source growth, or the like.

The number of graphene layers may be one or more. In the case of multilayer graphene, the number of graphene layers is 10 or less for thin graphene, 50 or less or 100 or less for graphene with a medium thickness, and 1,000 or more and 10,000 or less for thick graphene. Since the thickness varies in accordance with the number of graphene layers, it is possible to control performance of the thermal detector 10 or 10A. As the number of layers increases, i.e., the thickness increases, the heat capacity increases to reduce the speed of temperature change, i.e., sensitivity, while the mechanical strength can be increased. By thinning the graphene film to some extent for increasing the sensitivity, the thermal detector 10 or 10A can achieve either high sensitivity or high-speed operation, or both, thereby enhancing the performance. In particular, graphene has very high mechanical strength compared to any other type of material (materials, such as a metal, a semiconductor, and an insulator), and graphene that is thin in an atomic order can be used. This can significantly enhance the performance of the thermal detector 10 or 10A.

By introducing defects into graphene, the heat conductivity can be controlled, and thus the sensitivity and response speed of the thermal detector 10 or 10A can be designed as desired. For example, by artificially introducing defects into graphene through a heat treatment, ion irradiation, a chemical treatment, or the like, the heat conductivity can be reduced while maintaining the bridged structure of graphene. This suppresses the dissipation of heat to the electrodes 13 and 14 and the substrate 11, and can increase the sensitivity of the thermal detector 10 or 10A. A method of introducing defects into the nanocarbon material layer 15 can be similarly employed when using carbon nanotubes or graphene, which will be described below.

### <Second Embodiment>

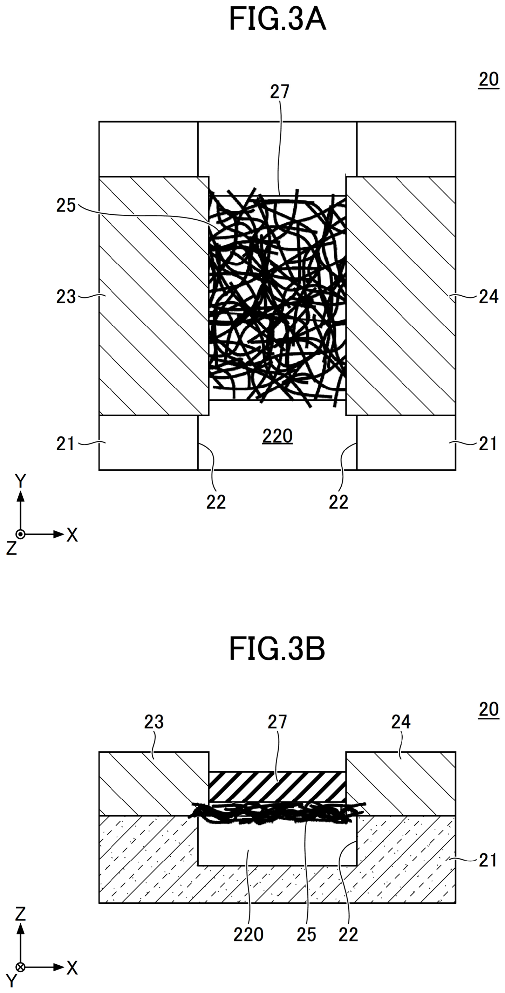

FIGS. 3A and 3B are schematic diagrams of a thermal detector 20 of a second embodiment. In the second embodiment, a thin film of carbon nanotubes is used as a nanocarbon material layer 25 serving as a template for forming a bridging structure of the thermal detector 20. FIG. 3A is a top diagram of the thermal detector 20, and FIG. 3B is a cross-sectional diagram of the thermal detector 20. A surface of the substrate 11 is an XY plane, and a thickness direction is a Z direction. In FIGS. 3A and 3B, for ease of understanding of a configuration, a resistance-changing material layer 27 is illustrated to be transparent such that the nanocarbon material layer 25 below the resistance-changing material layer 27 can be seen through. However, the resistance-changing material layer 27 does not need to be transparent. A light absorbing layer may be formed on the resistance-changing material layer 27.

The thermal detector 20 includes a recess 22 provided in a substrate 21, the nanocarbon material layer 25 bridged over the recess 22, the temperature-dependent resistance-changing material layer 27 supported by the nanocarbon material layer 25, and a pair of electrodes 23 and 24 connected to at least one of the resistance-changing material layer 27 or the nanocarbon material layer 25. The nanocarbon material layer 25 functions as a support film for supporting the resistance-changing material layer 27, and a space 220 is formed below the nanocarbon material layer 25. The nanocarbon material layer 25 in FIGS. 3A and 3B is illustrated as a carbon nanotube film in which the carbon nanotubes are oriented in random directions. However, this example is by no means a limitation. As described below, a carbon nanotube film in which the carbon nanotubes are oriented in a specific direction may be used. In FIGS. 3A and 3B, for ease of understanding of how the carbon nanotubes are oriented, the density of the carbon nanotubes is illustrated to be low, i.e., as a loose thin film with gaps. However, in reality, a dense carbon nanotube thin film without gaps can be used.

As illustrated in FIG. 3B, the recess 22 is formed in the substrate 21, and the space 220 is provided below the nanocarbon material layer 25. In fabricating a bridging structure, the formation of the nanocarbon material layer 25 of the carbon nanotubes, the formation of the resistance-changing material layer 27, and the etching of the substrate 21 for providing the recess 22 may be performed in any order. After the nanocarbon material layer 25 and the resistance-changing material layer 27 are formed over the substrate 21, a portion of the substrate 21 below the nanocarbon material layer 25 may be removed, for example, through isotropic etching. The carbon nanotubes forming the nanocarbon material layer 25 may be formed by any method, such as chemical vapor deposition, spin coating, dip coating, or the like.

The thickness of the carbon nanotube film can be changed in accordance with a growth method or period of the carbon nanotubes, or a deposition method or period of the carbon nanotubes. The carbon nanotube film can be designed to have a desired thickness and a desired density. As the thickness or density of the carbon nanotube film increases, the heat capacity increases, and the detection sensitivity and the detection speed tend to decrease. Conversely, as the thickness or density of the carbon nanotube film increases, the mechanical strength increases to enhance the durability and simplicity of fabrication of the element. Since the heat capacity decreases by reducing the thickness or density of the carbon nanotube film, the sensitivity and the detection speed of the detector can be increased. The thickness of the carbon nanotube film can be appropriately designed in accordance with the intended usage environment and purpose.

In a structure in which the density of the carbon nanotubes is reduced to form gaps between the carbon nanotubes in the carbon nanotube film, or a structure in which the surface of the carbon nanotube film is rough or uneven, thermal contact between the nanocarbon material layer 25 and the resistance-changing material layer 27 supported by the nanocarbon material layer 25 is weakened. This suppresses transfer of heat from the resistance-changing material layer 27 to the nanocarbon material layer 25, and increases the temperature change of the resistance-changing material layer 27 to increase the detection sensitivity. Also, reducing the density of the carbon nanotubes suppresses thermal contact between the carbon nanotubes in the nanocarbon material layer 25, thereby lowering the heat conductivity of the nanocarbon material layer 25. This can suppress the dissipation of heat to the substrate 21 to increase the sensitivity. Conversely, when the density of the carbon nanotubes is increased to increase the heat conductivity of the nanocarbon material layer 25, the transfer of heat to the substrate is increased, and the speed of the temperature change is increased. As a result, it is possible to achieve high-speed operation of the thermal detector 20.

As such, by reducing the density of the carbon nanotubes in the nanocarbon material layer 25, the heat conductivity of the nanocarbon material layer 25 can be reduced to suppress the dissipation of heat, thereby increasing the detection sensitivity and reducing the heat capacity. This enables the thermal detector 20 to exhibit both high sensitivity and high-speed operation.

### <Third Embodiment>

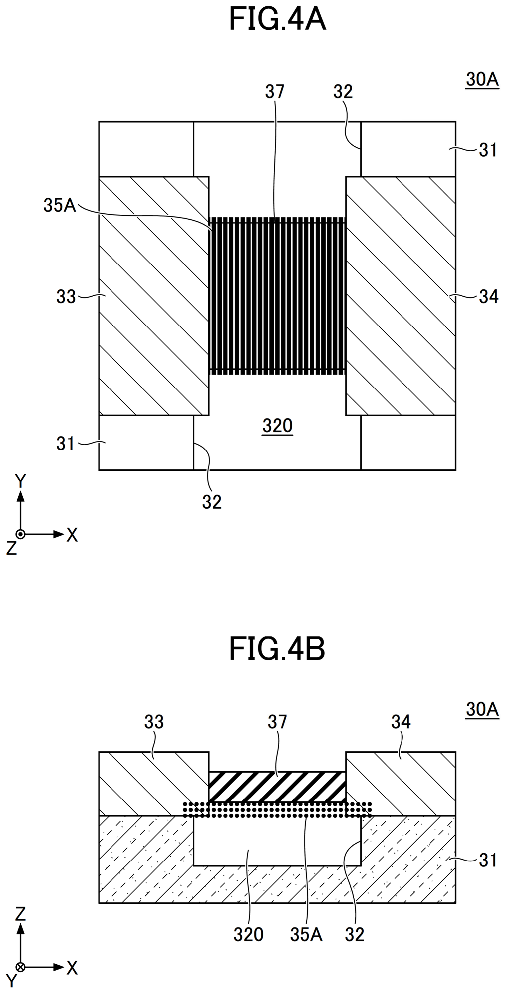

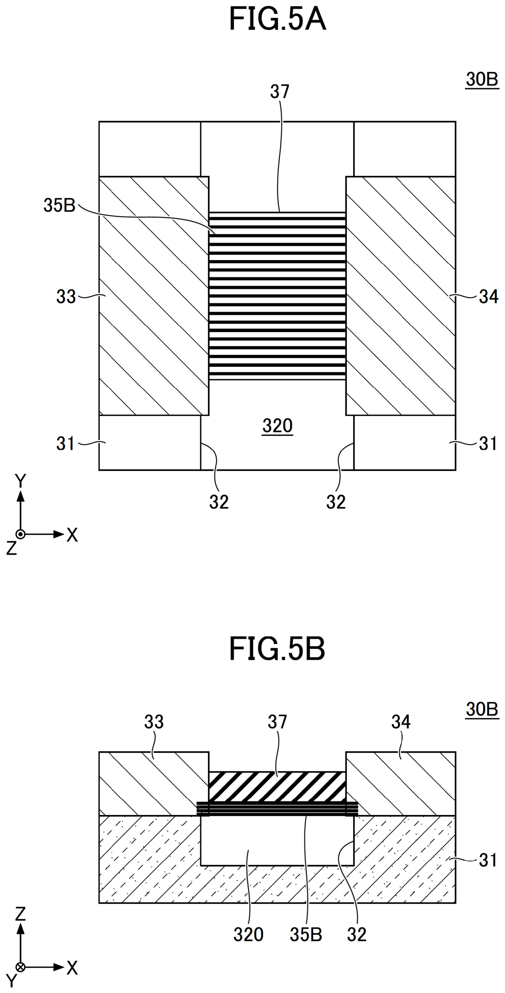

FIGS. 4A and 4B and FIGS. 5A and 5B are schematic diagrams of thermal detectors 30A and 30B of a third embodiment. In the third embodiment, an oriented carbon nanotube film, in which the directions of the carbon nanotubes are uniform, is used as a template for forming bridging structures of the thermal detectors 30A and 30B.

As illustrated in FIGS. 4A and 4B, the thermal detector 30A includes a recess 32 provided in a substrate 31, a nanocarbon material layer 35A bridged over the recess 32, a temperature-dependent resistance-changing material layer 37 supported by the nanocarbon material layer 35A, and a pair of electrodes 33 and 34 connected to at least one of the resistance-changing material layer 37 or the nanocarbon material layer 35A. The nanocarbon material layer 35A is bridged over the recess 32 to function as a support film for supporting the resistance-changing material layer 37, and a space 320 is formed below the nanocarbon material layer 35A.

In the configuration of FIGS. 4A and 4B, the nanocarbon material layer 35A is formed of carbon nanotubes oriented in a direction that intersects with a direction in which the electrodes 33 and 34 are connected. If the electrodes 33 and 34 are disposed in an X direction in an XY plane, the carbon nanotubes of the nanocarbon material layer 35A are oriented in a Y direction. That is, the carbon nanotubes extend in the direction that intersects with the direction in which the electrodes 34 and 34 are connected.

The basic detection principle of the thermal detector 30A and the characteristics or properties regarding the density and thickness of the carbon nanotube film are the same as those of the thermal detector 20 using the randomly oriented carbon nanotubes of FIGS. 3A and 3B. In addition to the properties obtained in FIGS. 3A and 3B, the carbon nanotube film of the carbon nanotubes oriented in a specific direction can be controlled for the heat conductivity due to the orientation direction. The heat conductivity increases in the orientation direction along the major axes of the carbon nanotubes, and decreases in a direction perpendicular to the orientation direction. In the configuration of FIGS. 4A and 4B, the heat conductivity in the Y direction increases, and the heat conductivity in the X direction decreases. Direction dependency of the heat conductivity on several orders of magnitude is observed for high-density oriented carbon nanotubes.

In the configuration of FIGS. 4A and 4B, the heat conductivity decreases in the X direction, which is a direction in which the electrodes 33 and 34 are disposed, thereby suppressing the dissipation of heat to the electrodes 33 and 34. This can increase the temperature change of the resistance-changing material layer 37 to increase the sensitivity of the thermal detector 30A.

In the thermal detector 30B of FIGS. 5A and 5B, the orientation direction of the carbon nanotubes is the same direction as the X direction in which the electrodes 33 and 34 are disposed. The carbon nanotubes extend in the direction in which the electrodes 34 and 34 are connected. Other configurations are the same as those of the thermal detector 30A of FIGS. 4A and 4B. That is, the thermal detector 30B includes the recess 32 provided in the substrate 31, a nanocarbon material layer 35B bridged over the recess 32, the temperature-dependent resistance-changing material layer 37 supported by the nanocarbon material layer 35B, and the pair of electrodes 33 and 34 connected to at least one of the resistance-changing material layer 37 or the nanocarbon material layer 35B. The nanocarbon material layer 35B is bridged over the recess 32 to function as a support film for supporting the resistance-changing material layer 37, and the space 320 is formed below the nanocarbon material layer 35B.

In the configuration of FIGS. 5A and 5B, the heat conductivity increases in the X direction in which the electrodes 33 and 34 are disposed, and heat can be efficiently conducted to the electrodes 33 and 34. Thus, high-speed operation of the thermal detector 30B can be achieved.

In FIGS. 4A and 4B and FIGS. 5A and 5B, for ease of understanding of the orientation of the carbon nanotubes, the nanocarbon material layers 35A and 35B are illustrated as loose oriented films with gaps. However, in reality, these are films in which the carbon nanotubes are highly densely arranged. In the third embodiment, the orientation direction of the carbon nanotubes can be selected in accordance with the intended usage environment and purpose, i.e., which to prioritize the detection sensitivity or the operation speed, thereby achieving temperature detection in accordance with the intended applications.

### <Fourth Embodiment>

FIGS. 6A and 6B are schematic diagrams of a thermal detector 40 of a fourth embodiment. The fourth embodiment provides the thermal detector 40 using a linear bridged carbon nanotube. The thermal detector 40 includes a recess 42 provided in a substrate 41, a nanocarbon material layer 45 bridged over the recess 42, a temperature-dependent resistance-changing material layer 47 supported by the nanocarbon material layer 45, and a pair of electrodes 43 and 44 connected to at least one of the resistance-changing material layer 47 or the nanocarbon material layer 45. The nanocarbon material layer 45 is bridged over the recess 42 to function as a support film for supporting the resistance-changing material layer 47, and a space 420 is formed below the nanocarbon material layer 45.

The resistance-changing material layer 47 is formed on the linear carbon nanotube including one or more carbon nanotubes, and the very small and thin thermal detector 40 is realized. Thus, the volume of the thermal detector 40 is small, and the linear carbon nanotube limits a current path for detection to be very thin, thereby suppressing a bypass current. It is possible to further increase the sensitivity compared to the thermal detector in the form of a planar thin film.

FIGS. 6A and 6B are illustrated as if there were a single carbon nanotube. However, the single carbon nanotube is by no means a limitation. Similar effects can be obtained by the linear carbon nanotube formed of a plurality of carbon nanotubes arranged in parallel or the linear carbon nanotube formed of a plurality of carbon nanotubes in a bundle. When the resistance-changing material layer 47 is formed on the linear nanocarbon material layer 45 through chemical vapor deposition, the nanocarbon material layer 45 can be enclosed by the resistance-changing material layer 47. For example, the resistance-changing material layer 45 encloses the nanocarbon material layer 45 from a direction of at least a part of a YZ plane.

The fourth embodiment uses one or more carbon nanotubes or the bundle thereof, as the support film. However, the effects similar to those obtained in the fourth embodiment can be obtained by a thin-line structure formed by graphene or carbon nanotubes, as described below.

### <Fifth Embodiment>

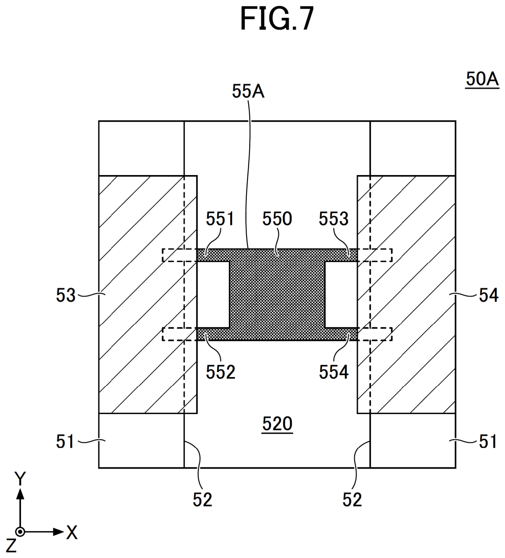

FIGS. 7, 8, and 9 are schematic plan diagrams of thermal detectors 50A, 50B, and 50C of a fifth embodiment. The fifth embodiment provides a thermal detector using a nanocarbon material layer with a shape in which heat dissipation is controlled. For ease of understanding of the shape of the nanocarbon material layer, FIGS. 7 to 9 illustrate a state prior to formation of the temperature-dependent resistance-changing material layer. In reality, the thermal detectors 50A, 50B, and 50C of the fifth embodiment include the resistance-changing material layer supported by the nanocarbon material layer.

In FIG. 7, the thermal detector 50A includes a recess 52 provided in a substrate 51, and a nanocarbon material layer 55A bridged over the recess 52. A temperature-dependent resistance-changing material layer is to be provided on the nanocarbon material layer 55A, and a pair of electrodes 53 and 54 are to be connected to at least one of the nanocarbon material layer 55A or the resistance-changing material layer. The nanocarbon material layer 55A functions as a support film for supporting the resistance-changing material layer, and a space 520 is formed below the nanocarbon material layer 55A. The nanocarbon material layer 55A may be a graphene film or a carbon nanotube film.

The nanocarbon material layer 55A has a shape in which the nanocarbon material layer 55A is supported at four points. The nanocarbon material layer 55A includes support legs 551, 552, 553, and 554, which extend in the XY plane parallel to the substrate surface and are bridged over the recess 52, and a support region 550, which is connected to the support legs 551, 552, 553, and 554 and supports the temperature-dependent resistance-changing material layer in the XY plane. Here, the reference to being "parallel" to the substrate surface refers to being "parallel" by design, and an actual device may have deflection and inclination due to the own weight of the nanocarbon material layer 55A and the weight of the resistance-changing material layer. In the example of FIG. 7, the support legs 551, 552, 553, and 554 extend from the four corners of the support region 550 to be parallel to each other, but may extend radially from the four corners of the support region 550 toward the corresponding electrodes 53 and 54.

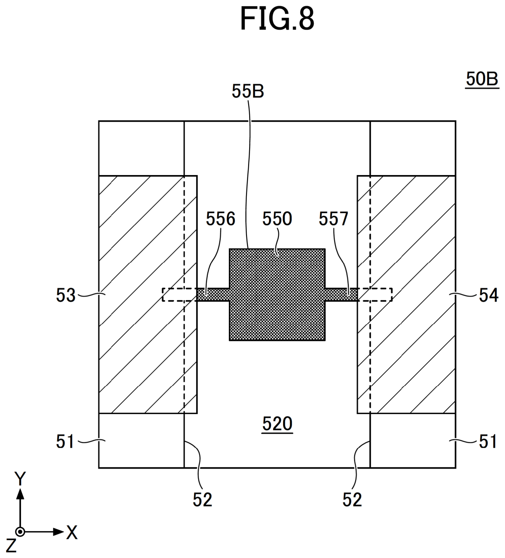

In FIG. 8, the thermal detector 50B includes the recess 52 provided in the substrate 51, and a nanocarbon material layer 55B bridged over the recess 52. A temperature-dependent resistance-changing material layer is to be provided on the nanocarbon material layer 55B, and the pair of electrodes 53 and 54 are to be connected to at least one of the nanocarbon material layer 55B or the resistance-changing material layer. The nanocarbon material layer 55B functions as a support film for supporting the resistance-changing material layer, and the space 520 is formed below the nanocarbon material layer 55B. The nanocarbon material layer 55B may be a graphene film or a carbon nanotube film.

The nanocarbon material layer 55B has a shape in which the nanocarbon material layer 55B is supported at two points. The nanocarbon material layer 55B includes support legs 556 and 557, which extend in the XY plane parallel to the substrate surface and are bridged over the recess 52, and the support region 550, which is connected to the support legs 556 and 557 and supports the temperature-dependent resistance-changing material layer in the XY plane. The support legs 556 and 557 have a straight shape extending from the support region 550 toward the pair of electrodes 53 and 54. Here, the reference to being "parallel" to the substrate surface refers to being "parallel" by design, and an actual device may have deflection and inclination due to the own weight of the nanocarbon material layer 55B and the weight of the resistance-changing material layer. For example, the width of the support region 550 in the Y direction is greater than the widths of the support legs 556 and 557 in the Y direction.

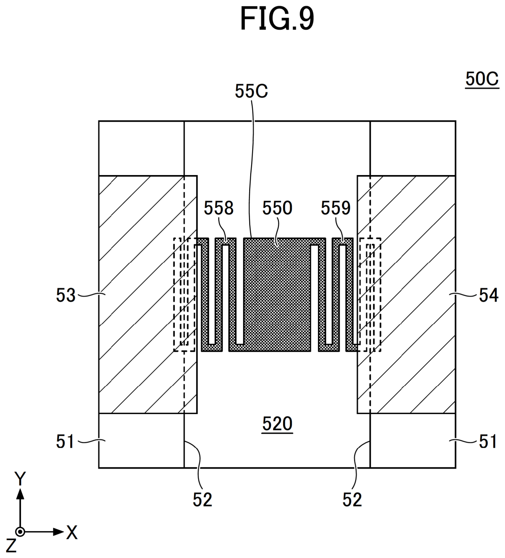

In FIG. 9, the thermal detector 50C includes the recess 52 provided in the substrate 51, and a nanocarbon material layer 55C bridged over the recess 52. A temperature-dependent resistance-changing material layer is to be provided on the nanocarbon material layer 55C, and the pair of electrodes 53 and 54 are to be connected to at least one of the nanocarbon material layer 55C or the resistance-changing material layer. The nanocarbon material layer 55C functions as a support film for supporting the resistance-changing material layer, and the space 520 is formed below the nanocarbon material layer 55C. The nanocarbon material layer 55C may be a graphene film or a carbon nanotube film.

The nanocarbon material layer 55C has a meandering shape. The nanocarbon material layer 55C includes support legs 558 and 559 each having a meandering structure, which extend in the XY plane parallel to the substrate plane and are bridged over the recess 52, and the support region 550, which is connected to the support legs 558 and 559 and supports the temperature-dependent resistance-changing material layer in the XY plane. The planar shapes of the support legs 558 and 559 are meandering shapes. Here, the reference to being "parallel" to the substrate surface refers to being "parallel" by design, and an actual device may have deflection and inclination due to the own weight of the nanocarbon material layer 55B and the weight of the resistance-changing material layer. In the example of FIG. 9, the support region 550 has a rectangular shape, but may have a meandering structure as in the support legs 558 and 559.

In the thermal detectors 50A, 50B, and 50C of the fifth embodiment, heat conduction is suppressed using the thin linear support legs 551 to 554 and 556 to 559, thereby suppressing dissipation of heat from the resistance-changing material layer, supported by the nanocarbon material layers 55A, 55B, and 55C, to the electrodes 53 and 54 and the substrate 51. Thus, the temperature change of the resistance-changing material layer increases to increase the detection sensitivity of the thermal detectors 50A, 50B, and 50C. The shape of the support region 550 of the nanocarbon material layers 55A, 55B, and 55C is not limited to a rectangle, and may be patterned into a desired shape that can support the resistance-changing material layer, such as a polygon, a circle, an ellipse, or the like.

### <Sixth Embodiment>

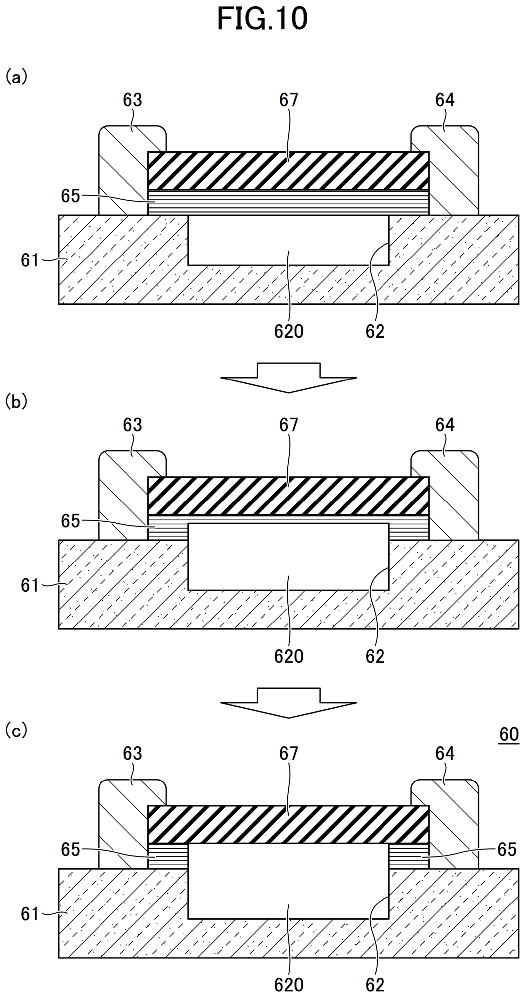

FIG. 10 is a schematic diagram illustrating the fabrication of a thermal detector 60 of a sixth embodiment. In the first to fifth embodiments, the nanocarbon material layer formed as the template is used as the support as is. However, it is possible to remove a portion of the nanocarbon material layer, serving as the support, to thin the nanocarbon material layer. Alternatively, it is possible to leave the nanocarbon material layer only on the surface of the substrate in the vicinity of the edges of the recess, and cause only the resistance-changing material layer to be bridged over the recess.

In (a) of FIG. 10, a resistance-changing material layer 67 supported by a nanocarbon material layer 65 is bridged over a recess 62 formed in a substrate 61. The planar shapes of the nanocarbon material layer 65 and the resistance-changing material layer 67 may be any of the shapes in the first embodiment, the fourth embodiment, and the fifth embodiment. The nanocarbon material layer 65 may be formed of the carbon nanotubes oriented in random directions as in the second embodiment, or may be formed of the carbon nanotubes oriented in a predetermined direction as in the third embodiment.

In (b) of FIG. 10, a portion of the nanocarbon material layer 65 is removed by a heat treatment in oxygen, such as oxygen plasma ashing or the like. The oxygen plasma preferentially removes a portion of the nanocarbon material layer 65 exposed in a space 620 of the recess 62, thereby thinning the nanocarbon material layer 65 in the space 620. When the nanocarbon material layer 65 is thinned to some extent, etching may be ended to leave a thin film of the nanocarbon material layer 65 below the resistance-changing material layer 67. Since the thickness, defects, and density of the nanocarbon material layer can be changed by thinning the thin film of the nanocarbon material layer 65, characteristics, such as sensitivity, speed, and the like, can be controlled in the same manner as in the first and second embodiments. When the thin film of the nanocarbon material layer 65 is left, this thin film may be used as a portion of the resistance-changing material layer 67.

In (b) of FIG. 10, the etching may be further performed to completely remove the nanocarbon material layer 65 in the space 620 of the recess 62, as illustrated in (c) of FIG. 10. In this case, the resistance-changing material layer 67 is supported by the nanocarbon material layer 65 only on the surface of the substrate 61 in the vicinity of the edges of the recess 62. Even if a portion of the nanocarbon material layer 65 is removed in the space 620 of the recess 62 as illustrated in (b) or (c) of FIG. 10, the resistance-changing material layer 67 is stably bridged over the recess 62 by the nanocarbon material layer 65 and the electrodes 63 and 64 located on the surface of the substrate 61. The configuration of the sixth embodiment still suppresses dissipation of heat to the substrate 61 by provision of the recess 62, and relatively increases the temperature change of the resistance-changing material layer 67, thereby achieving detection with high sensitivity.

### <Preparation of Sample>

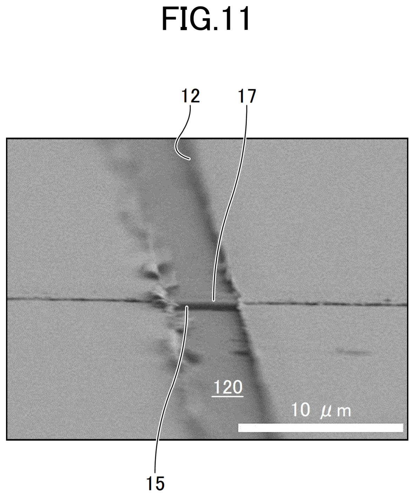

FIG. 11 is an SEM image of a prepared sample. This SEM image is an image of a state in which the resistance-changing material layer 17, supported by the nanocarbon material layer 15 and bridged over the recess 12, is formed, and in which electrodes are not formed. A groove having a width of 5 µm and a depth of 1 µm is formed through dry etching in a silicon oxide film on the substrate surface, thereby forming the recess 12 having the space 120. Multilayer graphene is bridged over the recess 12 as the nanocarbon material layer 15. The resistance-changing material layer 17 of platinum (Pt) is formed through sputtering on the bridged multilayer graphene. The multilayer graphene may be thinned after the formation of the resistance-changing material layer 17. The recess 12 can suppress dissipation of heat to the substrate, and relatively increase the temperature change of the resistance-changing material layer 17.

As such, in the first to sixth embodiments, the thin nanocarbon material layer is used as the support structure, and the low heat capacity and the high heat conductivity are effectively utilized to increase at least one of the sensitivity or the response speed of the thermal detector. The above-described embodiments can be combined with each other. For example, the light absorbing layer provided on the resistance-changing material in the first embodiment may be applied to the resistance-changing material in the second to sixth embodiments. The support region 550 in the fifth embodiment may be formed by the carbon nanotubes oriented in the specific direction as in the third embodiment. A portion of the nanocarbon material layer in the first to fifth embodiments may be thinned or removed. The nanocarbon material layer can be readily formed over the substrate, which is a semiconductor substrate of silicon or the like. The ability to readily control the shape, orientation, crystallinity, and the like of the nanocarbon material can readily change thermal properties, and achieve high sensitivity and high-speed operation. Since the nanocarbon material has high mechanical strength, a very thin film of the nanocarbon material can be designed in various shapes, and thus the degree of freedom in design and the degree of freedom of control of thermal characteristics are high. Compared to the conventional silicon-based thermal detectors, a thin, high-speed, and highly sensitive thermal detector is realized.

### <Seventh Embodiment>

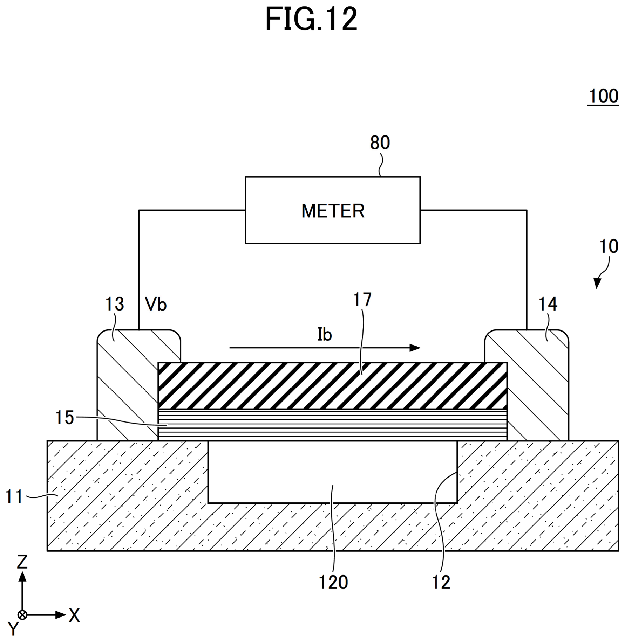

FIG. 12 is a schematic diagram of a detection device of a seventh embodiment. As illustrated in FIG. 12, a detection device 100 includes the thermal detector 10 and a meter 80. The meter 80 is configured to apply a bias voltage Vb or a bias current Ib between the electrodes 13 and 14. When the bias voltage Vb is applied between the electrodes 13 and 14, the meter 80 measures a current value between the electrodes 13 and 14 to calculate a resistance value between the electrodes 13 and 14. When the bias current Ib is applied between the electrodes 13 and 14, the meter 80 measures a voltage value between the electrodes 13 and 14 to calculate a resistance value between the electrodes 13 and 14. The meter 80 calculates, from the calculated resistance value, an intensity of light applied to the resistance-changing material layer 17.

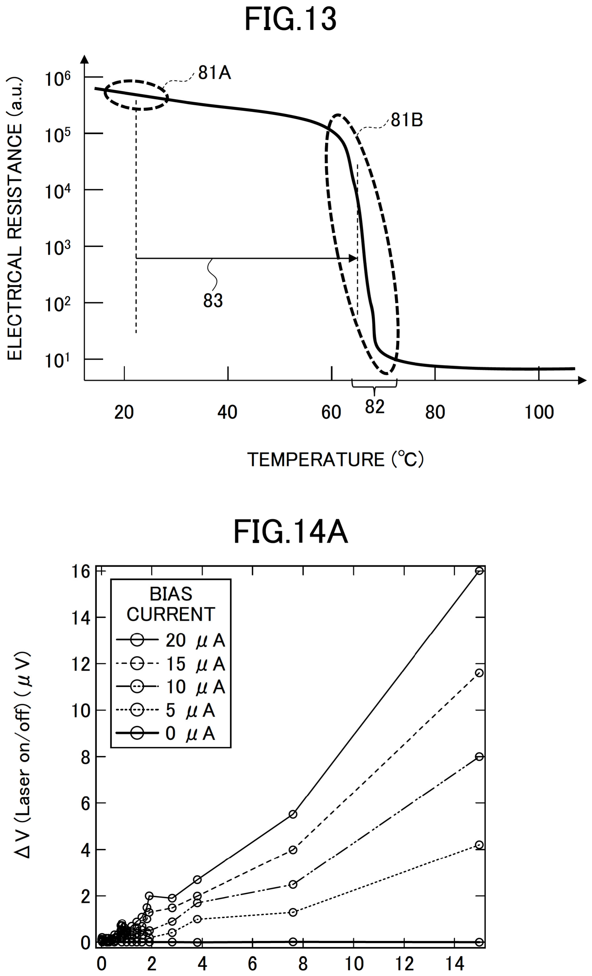

FIG. 13 is a graph illustrating an example of an electrical resistance with respect to a temperature in vanadium oxide. As illustrated in FIG. 13, vanadium oxide has high electrical resistance at room temperature around 25°C as illustrated in a range 81A, and the absolute value of the change in the electrical resistance with respect to the temperature is not so large. Vanadium oxide undergoes a phase transition between 60°C and 80°C. Thus, the electrical resistance is low at 80°C or higher, and the absolute value of the change in the electrical resistance with respect to the temperature is not so large. Between 60°C and 80°C, the absolute value of the change in the electrical resistance with respect to the temperature is very large, as illustrated in a range 81B. FIG. 13 is one example, and vanadium oxide exhibits significant resistance change at a temperature from room temperature to 100°C due to the phase transition. In particular, vanadium oxide exhibits significant resistance change in a range from 50°C to 80°C.

Therefore, the meter 80 applies the voltage Vb or the current Ib between the electrodes 13 and 14 to set, as indicated by an arrow 83, the temperature of the resistance-changing material layer 17 to a range 82 in which the resistance of the resistance-changing material layer 17 abruptly changes. Then, the meter 80 measures resistance change of the resistance-changing material layer 17 from the voltage Vb or the current Ib applied to the electrodes 13 and 14. Thus, even if the temperature of the resistance-changing material layer 17 slightly changes by application of light to the resistance-changing material layer 17, the resistance of the resistance-changing material layer 17 greatly changes. Therefore, it is possible to increase detection accuracy of the light intensity. The range 82 of the temperature set by the meter 80 is a range in which the absolute value |ΔR1/ΔT1| of a change in a resistance R1 with respect to a temperature T1 of the resistance-changing material layer 17 is greater than the absolute value |ΔR0/ΔT0| of a change in a resistance R0 with respect to a temperature T0 of the resistance-changing material layer 17 without the voltage Vb or the current Ib being applied between the electrodes 13 and 14. The absolute value |ΔR1/ΔT1| is preferably two times or greater the absolute value |ΔR0/ΔT0|, and more preferably 10 times or greater the absolute value |ΔR0/ΔT0|.

In the seventh embodiment, the voltage Vb or the current Ib applied to the electrodes 13 and 14 can be used not only to measure the resistance, but also to set the temperature of the resistance-changing material layer 17. The current flowing through the nanocarbon material layer 15 can be used to control the temperature of the resistance-changing material layer 17. Also, since the nanocarbon material layer 15 is bridged over the substrate 11, it is possible to suppress dissipation of heat from the nanocarbon material layer 15 to the substrate 11. This can control the temperature by a low bias current or a low bias voltage.

When the resistance-changing material layer 17 undergoes a phase transition, a structural change may occur in the resistance-changing material layer 17 or the nanocarbon material layer 15 due to change in the crystal structure of the resistance-changing material layer 17. By using this structural change, it is possible to obtain change in electrical resistance due to change in a path of a current flowing through the resistance-changing material layer 17 or the nanocarbon material layer 15 or due to change in a contact state between the resistance-changing material layer 17 or the nanocarbon material layer 15 and the electrodes 13 and 14. In this manner, in addition to the resistance change of the resistance-changing material layer 17 or the nanocarbon material layer 15 caused by the temperature, the resistance change caused by the structural change can be used. Since the nanocarbon material layer 15 is bridged, the structural change of the resistance-changing material layer 17 or the nanocarbon material layer 15 is not limited by the substrate 11. Therefore, the resistance change caused by the structural change can be increased.

The thermal detector used may be the thermal detector of the second to sixth embodiments. The material of the resistance-changing material layer 17 may be a material other than vanadium oxide as long as |ΔR1/ΔT1| is larger than |ΔR0/ΔT0| in the material. The material of the resistance-changing material layer 17 is preferably a material that undergoes a phase transition at a temperature higher than room temperature, and greatly changes in resistance.

### <Measurement Results of Samples>

Samples A, B, and C were prepared and used to detect light.

### <Sample A>

In Sample A, multilayer polycrystalline graphene was used for both the nanocarbon material layer 15 and the resistance-changing material layer 17. A fabricated structure is the structure illustrated in FIGS. 1A and 1B of the first embodiment, and the total thickness of the nanocarbon material layer 15 and the resistance-changing material layer 17 is 200 nm. The size of the plane of the bridged nanocarbon material layer 15 is 5 µm×5 µm.

Light to be applied to the upper surface of the resistance-changing material layer 17 was mid-infrared light having a wavelength of 4.6 µm. A bias current was applied between a pair of electrodes (e.g., the electrodes 23 and 24, the electrodes 33 and 34, the electrodes 43 and 44, the electrodes 53 and 54, or the electrodes 63 and 64) to turn the light on or off. The difference between: the voltage between the pair of electrodes with the light on; and the voltage between the pair of electrodes with the light off was defined as ΔV.

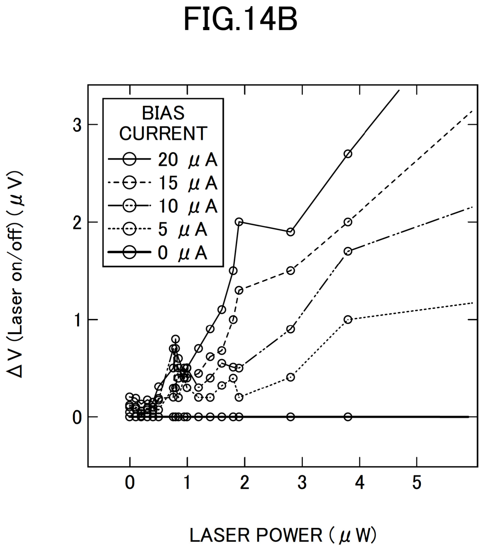

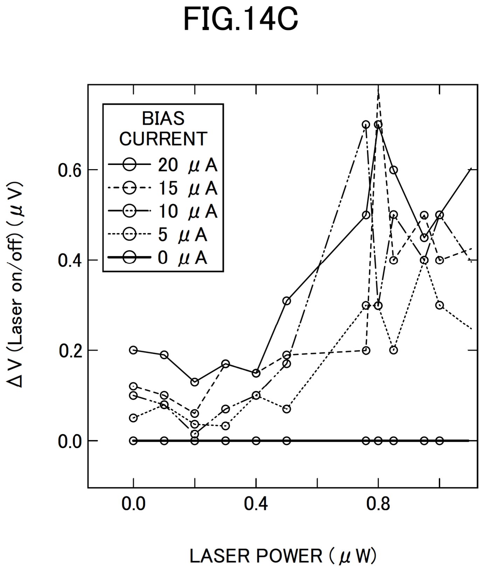

FIGS. 14A to 14C are graphs illustrating the ΔV with respect to laser power in Sample A. The bias current is changed from 0 µA to 20 µA in increments of 5 µA. FIG. 14A is a graph of a range in which the laser power is about 15 µW or less. FIG. 14B is a graph of a range in which the laser power is about 4 µW or less. FIG. 14C is a graph of a range in which the laser power is about 0.9 µW or less.

As illustrated in FIGS. 14A and 14B, as the laser power increases, the ΔV increases to be substantially in proportion to the laser power. That is, the overall resistance between the electrodes increases as the laser power increases. Thus, it is possible to detect the light intensity by measuring the resistance between the electrodes. As illustrated in FIG. 14C, when the laser power is 0.4 µW or more, the ΔV increases as the laser power increases. Thus, light detection is possible when the laser power is 0.4 µW or more. Similar to the other sample examples, the minimum power at which light detection is possible greatly depends on the structure or the like of the optical detector. Therefore, the minimum power at which light detection is possible can be further reduced. The value of 0.4 µW in Sample A is merely an example, and the minimum power at which light detection is possible in the present disclosure is not limited to 0.4 µW, and light detection at still lower power, such as, for example, 0.1 µW or less, is possible in accordance with a design.

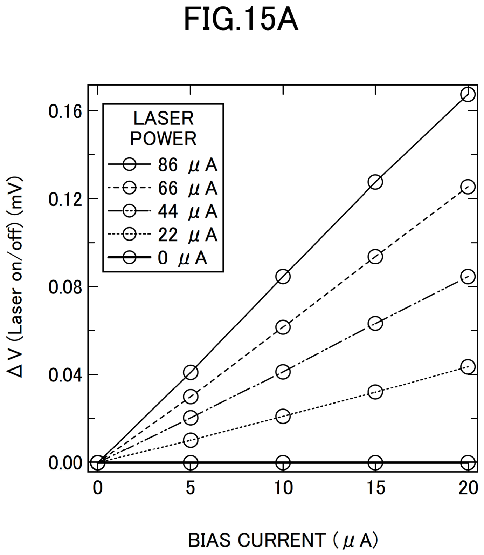

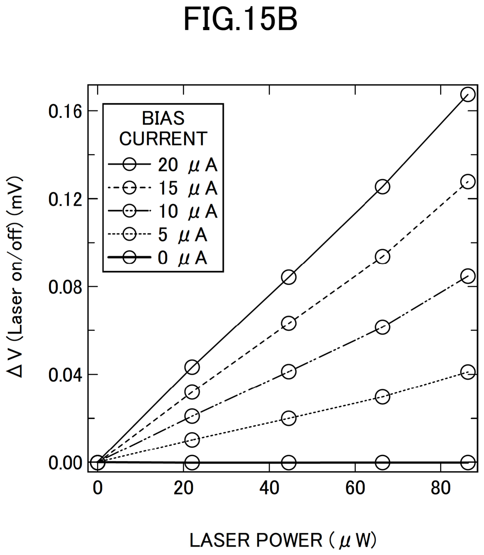

FIG. 15A is a graph illustrating the ΔV with respect to the bias current in Sample A. FIG. 15B is a graph illustrating the ΔV with respect to the laser power in Sample A. In FIG. 15A, the laser power is changed from 0 µW to 88 µW in increments of 22 µW. In FIG. 15B, the bias current is changed from 0 µA to 20 µA in increments of 5 µA.

As in FIGS. 15A and 15B, until the laser power is 88 µW, the ΔV is proportional to the bias current and is proportional to the laser power. Thus, Sample A can be used as an optical detector with good linearity. The optical detector can detect high-power light with a desired magnitude on the side in which the power of light is higher. For example, light with laser power of about 10 mW or about 100 mW can be detected without any problem. Also, light with power higher than 100 mW can be detected. Further, by introducing an ND filter (neutral density filter) or the like in front of the optical detector, any high-intensity light can be substantially measured.

### <Sample B>

In Sample B, multilayer polycrystalline graphene was used as the nanocarbon material layer 15. Vanadium oxide (VO₂) was used as the resistance-changing material layer 17. A fabricated structure is the structure illustrated in FIGS. 1A and 1B of the first embodiment, and the thickness of the nanocarbon material layer 15 is 200 nm and the thickness of the resistance-changing material layer 17 is 100 nm. The size of the plane of the bridged nanocarbon material layer 15 and the resistance-changing material layer 17 is 5 µm×5 µm. Light to be applied to the upper surface of the resistance-changing material layer 17 was mid-infrared light having a wavelength of 4.6 µm.

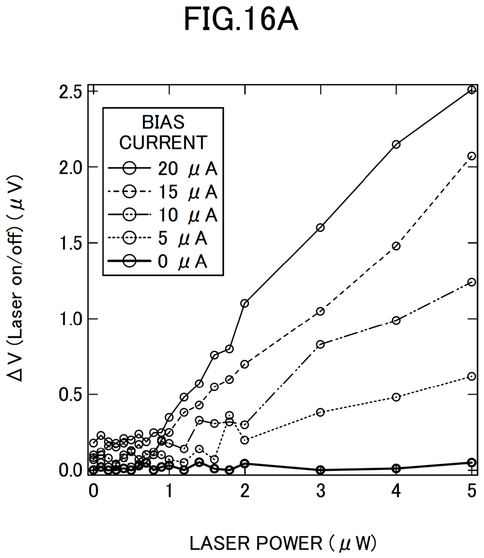

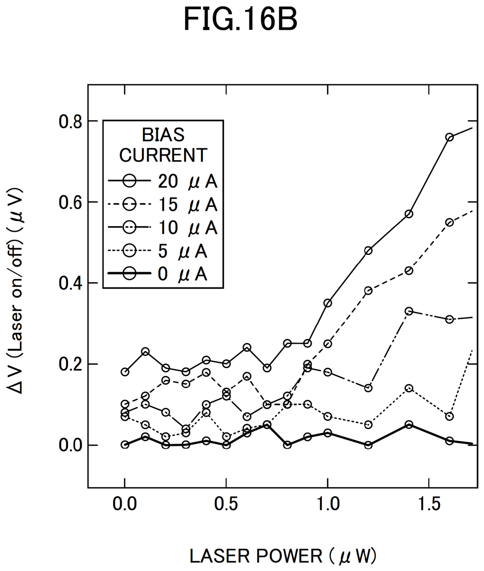

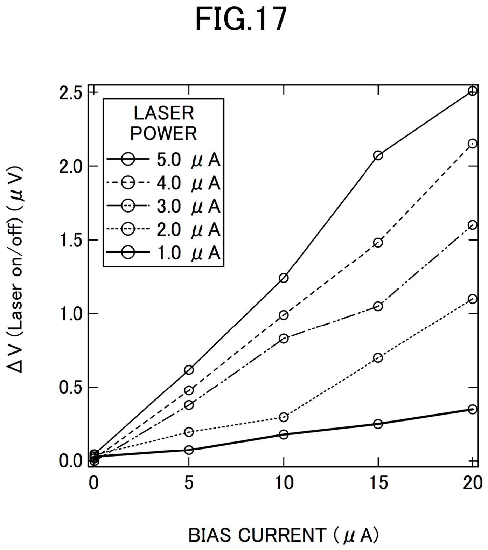

FIGS. 16A and 16B are graphs illustrating the ΔV with respect to the laser power in Sample B. FIG. 17 is a graph illustrating the ΔV with respect to the bias current in Sample B. In FIGS. 16A and 16B, the bias current is changed from 0 µA to 20 µA in increments of 5 µA. FIG. 16A is a graph of a range in which the laser power is about 5 µW or less. FIG. 16B is a graph of a range in which the laser power is about 1.6 µW or less. In FIG. 17, the laser power is changed from 1 µW to 5 µA in increments of 1 µA.

As illustrated in FIGS. 16A and 17, as the laser power increases, the ΔV increases to be substantially in proportion to the laser power and the ΔV increases to be substantially in proportion to the bias current. When the bias current is 0 µA, the ΔV is substantially 0 µV. Thus, the light intensity can be detected by measuring the resistance between the electrodes. As illustrated in FIG. 16B, when the laser power is 0.6 µW or more, the ΔV increases as the laser power increases, and light detection is possible when the laser power is 0.6 µW or more.

### <Sample C>

In Sample C, the nanocarbon material layer 15 and the resistance-changing material layer 17 are the same as those of Sample B. A fabricated structure is the same as that of Sample B. Light to be applied to the upper surface of the resistance-changing material layer 17 was mid-infrared light having a wavelength of 4.6 µm.

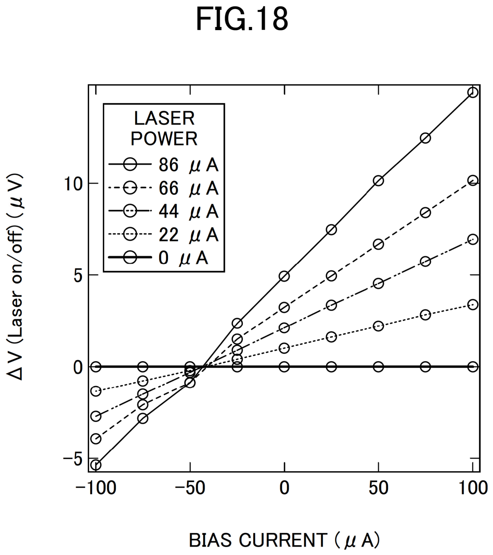

FIG. 18 is a graph illustrating the ΔV with respect to the bias current in Sample C. The laser power is changed from 0 µW to 88 µW in increments of 22 µW. As illustrated in FIG. 18, the ΔV increases as the bias current increases, and the ΔV increases as the laser power increases. This tendency is the same as that in sample B. When the laser power is not 0 µW, the ΔV is a positive value even if the bias current is 0 µA.

This is considered to be due to generation of photovoltaic or thermoelectric power at the junction among: the semiconductor vanadium oxide; the electrode; and the nanocarbon material layer 15. The photovoltaic or thermoelectric power is considered to be generated through bending of the energy band of the resistance-changing material layer 17 or the spatial change in the energy gap or the carrier concentration distribution of the resistance-changing material layer 17 due to various factors, such as a Schottky barrier generated at the junction or a pn junction formed by the junction of a plurality of materials. Such photovoltage or thermoelectric power can be used in the optical detector. It is considered that Samples B and C do not necessarily generate the photovoltaic or thermoelectric power due to the difference in the structure or dimensions at the time of fabrication. Due to the photovoltaic or thermoelectric power between the nanocarbon material layer 15 and the resistance-changing material layer 17, a voltage or current offset occurs between the electrodes 13 and 14, and enables light detection at a low bias voltage or a low bias current (e.g., the bias voltage Vb is 0 V or the bias current Ib is 0 A).

Sample A can detect light with laser power of 0.4 µW or more, and Sample B can detect light with laser power of 0.6 µW or more. Also, Samples A and C can detect light up to at least about 100 µW. By optimizing the structure of the optical detector, it is possible to detect light with a lower intensity or light with a higher intensity. The numerical values in Samples A to C change in accordance with the structure and dimensions of the samples, and are not limited to the above measurement results. In the above measurement, mid-infrared light was used as the light to be applied. In addition to the mid-infrared light, ultraviolet light, visible light, near-infrared light, and mid-infrared light can be detected by the optical detector.

As in Sample A, the material of the nanocarbon material layer 15 and the material of the resistance-changing material layer 17 may be the same. This can reduce the number of steps for forming the resistance-changing material layer 17. As in Sample B, a material other than the nanocarbon material may be used as the resistance-changing material layer 17. As in Sample C, the optical detector may generate photovoltaic power.

Although preferred embodiments and the like have been described above in detail, the present invention is not limited to the above-described embodiments and the like. Various modifications and substitutions can be added to the above-described embodiments and the like without departing from the scope of the claims.

The above disclosure includes the following embodiments.

### (Clause 1)

A thermal detector, including:
a substrate;
a nanocarbon material layer bridged over the substrate;
a temperature-dependent resistance-changing material layer supported by the nanocarbon material layer; and
a pair of electrodes connected to at least one of the resistance-changing material layer or the nanocarbon material layer.

### (Clause 2)

The thermal detector according to clause 1, wherein
the substrate includes a recess, and
the nanocarbon material layer is bridged over the recess.

### (Clause 3)

The thermal detector according to clause 1 or 2, wherein
a portion of the nanocarbon material layer is thinned or removed.

### (Clause 4)

The thermal detector according to any one of clauses 1 to 3, wherein
the resistance-changing material layer is a metal, a metal oxide, a semiconductor, a superconductor, or a nanocarbon material.

### (Clause 5)

The thermal detector according to any one of clauses 1 to 3, wherein
a material of the nanocarbon material layer and a material of the resistance-changing material layer are same.

### (Clause 6)

The thermal detector according to any one of clauses 1 to 5, wherein
the pair of electrodes are connected to both the nanocarbon material layer and the resistance-changing material layer.

### (Clause 7)

The thermal detector according to any one of clauses 1 to 6, further including:
a light absorbing layer provided on the resistance-changing material layer.

### (Clause 8)

The thermal detector according to any one of clauses 1 to 7, wherein
the nanocarbon material layer is a thin film of carbon nanotubes that are randomly oriented.

### (Clause 9)

The thermal detector according to any one of clauses 1 to 7, wherein
the nanocarbon material layer is a thin film of carbon nanotubes extending in a direction in which the pair of electrodes are connected.

### (Clause 10)

The thermal detector according to any one of clauses 1 to 7, wherein
the nanocarbon material layer is a thin film of carbon nanotubes extending in a direction that intersects with a direction in which the pair of electrodes are connected.

### (Clause 11)

The thermal detector according to any one of clauses 1 to 7, wherein
the nanocarbon material layer is a linear support formed of one or more carbon nanotubes, and
the resistance-changing material layer encloses the linear support.

### (Clause 12)

The thermal detector according to any one of clauses 1 to 7, wherein
the nanocarbon material layer includes
a support leg that is formed of monolayer or multilayer graphene or carbon nanotubes and extends in a direction parallel to a substrate surface to be bridged over the substrate, and
a support region that is connected to the support leg and supports the resistance-changing material layer in a plane same as the support leg.

### (Clause 13)

The thermal detector according to clause 12, wherein
the support leg has a straight or meandering shape extending from the support region toward the pair of electrodes.

### (Clause 14)

The thermal detector according to any one of clauses 1 to 13, wherein
the nanocarbon material layer includes artificially introduced defects.

### (Clause 15)

The thermal detector according to any one of clauses 1 to 14, further including:
a meter configured to apply a voltage or a current between the pair of electrodes to set a temperature of the resistance-changing material layer such that an absolute value of a change in resistance with respect to the temperature of the resistance-changing material layer is greater than an absolute value of a change in resistance with respect to the temperature of the resistance-changing material layer without the voltage or the current being applied, thereby measuring the change in the resistance of the resistance-changing material layer using the voltage or the current.

### (Clause 16)

The thermal detector according to any one of clauses 1 to 16, wherein
due to photovoltaic or thermoelectric power between the nanocarbon material layer and the resistance-changing material layer, a voltage or current offset occurs between the pair of electrodes.

This application claims priority to basic patent application No. 2023-081418, filed with the Japan Patent Office on May 17, 2023, and basic patent application No. 2023-173142, filed with the Japan Patent Office on October 4, 2023, the entire contents of which are hereby incorporated by reference.

### REFERENCE SIGNS LIST

10, 10A, 20, 30A, 30B, 40, 50A, 50B, 50C, 60 Thermal detector
11, 21, 31, 41, 51, 61 Substrate
12, 22, 32, 42, 52, 62 Recess
13, 14, 23, 24, 33, 34, 43, 44, 53 Electrode
15, 25, 35A, 35B, 45, 55A, 55B, 55C, 65 Nanocarbon material layer
17, 27, 37, 47, 67 Resistance-changing material layer
18 Light absorbing layer
80 Meter
120, 220, 320, 420, 520, 620 Space

## Claims

1. A thermal detector, comprising:
a substrate;
a nanocarbon material layer bridged over the substrate;
a temperature-dependent resistance-changing material layer supported by the nanocarbon material layer; and
a pair of electrodes connected to at least one of the resistance-changing material layer or the nanocarbon material layer.

2. The thermal detector according to claim 1, wherein
the substrate includes a recess, and
the nanocarbon material layer is bridged over the recess.

3. The thermal detector according to claim 1, wherein
a portion of the nanocarbon material layer is thinned or removed.

4. The thermal detector according to claim 1, wherein
the resistance-changing material layer is a metal, a metal oxide, a semiconductor, a superconductor, or a nanocarbon material.

5. The thermal detector according to claim 1, wherein
a material of the nanocarbon material layer and a material of the resistance-changing material layer are same.

6. The thermal detector according to claim 1, wherein
the pair of electrodes are connected to both the nanocarbon material layer and the resistance-changing material layer.

7. The thermal detector according to claim 1, further comprising:
a light absorbing layer provided on the resistance-changing material layer.

8. The thermal detector according to claim 1, wherein
the nanocarbon material layer is a thin film of carbon nanotubes that are randomly oriented.

9. The thermal detector according to claim 1, wherein
the nanocarbon material layer is a thin film of carbon nanotubes extending in a direction in which the pair of electrodes are connected.

10. The thermal detector according to claim 1, wherein
the nanocarbon material layer is a thin film of carbon nanotubes extending in a direction that intersects with a direction in which the pair of electrodes are connected.

11. The thermal detector according to claim 1, wherein
the nanocarbon material layer is a linear support formed of one or more carbon nanotubes, and
the resistance-changing material layer encloses the linear support.

12. The thermal detector according to claim 1, wherein
the nanocarbon material layer includes
a support leg that is formed of monolayer or multilayer graphene or carbon nanotubes and extends in a direction parallel to a substrate surface to be bridged over the substrate, and
a support region that is connected to the support leg and supports the resistance-changing material layer in a plane same as the support leg.

13. The thermal detector according to claim 12, wherein
the support leg has a straight or meandering shape extending from the support region toward the pair of electrodes.

14. The thermal detector according to claim 1, wherein
the nanocarbon material layer includes artificially introduced defects.

15. The thermal detector according to claim 1, further comprising:
a meter configured to apply a voltage or a current between the pair of electrodes to set a temperature of the resistance-changing material layer such that an absolute value of a change in resistance with respect to the temperature of the resistance-changing material layer is greater than an absolute value of a change in resistance with respect to the temperature of the resistance-changing material layer without the voltage or the current being applied, thereby measuring the change in the resistance of the resistance-changing material layer using the voltage or the current.

16. The thermal detector according to claim 1, wherein
due to photovoltaic or thermoelectric power between the nanocarbon material layer and the resistance-changing material layer, a voltage or current offset occurs between the pair of electrodes.
